# EUROPÄISCHE PATENTSCHRIFT

(11) **EP 0 976 165 B1**
(45) Veröffentlichungstag und Bekanntmachung des Hinweises auf die Patenterteilung: **24.01.2007**
(21) Anmeldenummer: 98928099.5
(22) Anmeldetag: 31.03.1998
(51) Int. Cl.: H01L 41/083

(54) **PIEZOAKTOR MIT NEUER KONTAKTIERUNG UND HERSTELLVERFAHREN**
PIEZO ACTUATOR WITH NOVEL CONTACTING AND PRODUCTION METHOD
ACTIONNEUR PIEZOELECTRIQUE A NOUVEAU MODE DE CONTACT ET SON PROCEDE DE FABRICATION

(30) Priorität: 14.04.1997 DE 19715488
(43) Veröffentlichungstag der Anmeldung: 02.02.2000
(73) Patentinhaber: SIEMENS AKTIENGESELLSCHAFT, 80333 München (DE)
(72) Erfinder: SCHUH, Carsten, D-85598 Baldham (DE); SCHERER, Clemens, D-82205 Gilching (DE); HEKELE, Wilhelm, D-83125 Eggstätt (DE); HAMANN, Christoph, D-85551 Kirchheim (DE)
(86) Internationale Anmeldenummer: PCT/DE1998/000917
(87) Internationale Veröffentlichungsnummer: WO 1998/047187

(56) Entgegenhaltungen:
- EP-A- 0 584 842

## Beschreibung

Piezoaktoren bestehen üblicherweise aus mehreren in einem Stapel angeordneten Piezoelementen. Jedes dieser Elemente wiederum besteht aus einer Piezokeramikschicht, die beiderseits mit metallischen Elektroden versehen ist. Wird an diese Elektroden eine Spannung angelegt, so reagiert die Piezokeramikschicht mit einer Gitterverzerrung, die entlang einer Hauptachse zu einer nutzbaren Längenausdehnung führt. Da diese wiederum weniger als zwei Promille der Schichtdicke entlang der Hauptachse beträgt, muß zur Erzielung einer gewünschten absoluten Längenausdehnung eine entsprechend höhere Schichtdicke aktiver Piezokeramik bereitgestellt werden. Mit zunehmender Schichtdicke der Piezokeramikschicht innerhalb eines Piezoelementes steigt jedoch auch die zum Ansprechen des Piezoelementes erforderliche Spannung. Um diese in handhabbaren Grenzen zu erhalten, werden Mehrschichtaktoren hergestellt, bei denen die Dicken von Piezoeinzelelementen üblicherweise zwischen 20 und 200 µm liegen.

Bekannte Piezoaktoren in Vielschichtbauweise bestehen daher aus insgesamt bis zu einigen hundert Einzelschichten. Zu deren Herstellung werden Piezokeramikgrünfolien alternierend mit Elektrodenmaterial zu einem Stapel angeordnet und gemeinsam zu einem monolithischen Verbund von bis zu ca. 5 mm Höhe laminiert und gesintert. Größere Aktoren mit größerer absoluter Auslenkung können beispielsweise durch Verkleben mehrerer solcher Stapel erhalten werden. Ausreichend hohe Steifigkeiten, insbesondere wenn mit dem Piezoaktor hohe Kräfte übertragen werden müssen, besitzen nur Piezoaktoren in voll monolithischer Vielschichtbauweise.

Zur elektrischen Kontaktierung solcher Piezoaktoren in Vielschichtbauweise werden beispielsweise Metallisierungsstreifen an der Außenseite des Piezoaktors oder auch in einer Bohrung in der Flächenmitte der Einzelaktoren angebracht. Um beispielsweise jede zweite Elektrodenschicht mit einem der Metallisierungsstreifen zu verbinden, muß dieser gegen die dazwischenliegenden Elektrodenschichten isoliert werden. Dies gelingt in einfacher Weise dadurch, daß jede zweite Elektrodenschicht im Bereich des einen Metallisierungsstreifens eine Aussparung aufweist, in der sie nicht bis zum Metallisierungsstreifen geführt wird. Die übrigen Elektrodenschichten weisen die Aussparungen dann im Bereich des zweiten Metallisierungsstreifens auf, um eine Kontaktierung mit alternierender Polarität zu ermöglichen. An die Metallisierungsstreifen sind Drähte für den elektrischen Anschluß angelötet. Ein solcher Aktor ist aus EP-A-0 584 842 bekannt.

Piezoaktoren, deren alternierende Kontaktierung über Aussparungen der Elektrodenschichten erfolgt, sind im Kontaktierungsbereich piezoelektrisch inaktiv, da sich dort durch die jeweils eine fehlende Elektrode kein elektrisches Feld aufbauen kann. Dies hat sowohl bei der Polarisation als auch beim Betrieb des Piezoaktors zur Folge, daß sich in diesem piezoelektrisch inaktiven Kontaktierungsbereich mechanische Spannungen aufbauen, die zu Rissen in den inaktiven Bereichen und damit auch an den Metallisierungsstreifen parallel zu den Elektrodenschichten führen können. Dies kann zum vollständigen Durchtrennen der Metallisierungsstreifen führen und hat zur Folge, daß bei punktförmiger Spannungszuführung von außen an die Metallisierungsstreifen ein Teil des Piezoaktors von der Stromversorgung abgehängt und damit inaktiv wird. Die Zahl der Risse hängt von der Gesamthöhe des Aktors sowie von der Festigkeit der Grenzfläche Innenelektrode/Piezokeramik ab und kann sich auch im Dauerbetrieb bei wechselnden Lastbedingungen weiter erhöhen. Da sich beim dynamischen Betrieb außerdem eine dynamische Veränderung der Risse bzw. der Rißöffnungen ergibt, werden dadurch die Metallisierungsstreifen während des Betriebs des Aktors weiter geschädigt.

Aufgabe der vorliegenden Erfindung ist es, einen keramischen Aktor samt Herstellverfahren anzugeben, der eine sichere und gut handhabbare elektrische Kontaktierung besitzt, die eine erhöhte Stabilität gegenüber einer Rißbildung zeigt.

Diese Aufgabe wird erfindungsgemäß durch einen Aktor nach Anspruch 1 gelöst. Vorteilhafte Ausgestaltungen der Erfindung sowie ein Verfahren zur Herstellung des Piezoaktors sind weiteren Ansprüchen zu entnehmen.

Der erfindungsgemäße Aktor kann einen herkömmlichen und vorzugsweise monolithischen Aufbau besitzen. Stapelartig sind alternierend piezoelektrische Keramikschichten und Elektrodenschichten übereinander angeordnet und vorzugsweise zusammen gesintert. Außen am Stapel sind zur alternierenden Kontaktierung der Elektrodenschichten erfindungsgemäß zumindest zwei elektrisch leitende Kontaktfahnen vorgesehen. Diese sind über eine Kante mit den Elektrodenschichten verbunden und erstrecken sich über die gesamte Höhe des elektrisch aktiven Bereichs des Stapels. Seitlich der verbundenen Kante weisen sie einen überstehenden Bereich und im Bereich der vom Stapel wegweisenden Außenkante ein seitlich oder den Stapel in der Höhe überragendes elektrisches Anschlußelement auf.

Mit der Kontaktfahne ist es möglich, eventuell im Betrieb des Aktors auftretende Risse in den Metallisierungen elektrisch leitend zu überbrücken. Wird der überstehende Bereich ausreichend breit gewählt, so laufen die Risse innerhalb der Kontaktfahne bzw. innerhalb des überstehenden Bereichs aus. So bleiben sämtliche Einzelelemente des Aktors elektrisch funktionsfähig, selbst wenn Risse an den Metallisierungen auftreten. Der erfindungsgemäße Aktor zeigt daher beim Betrieb keinerlei Leistungseinbußen.

Das Anschlußelement an der Außenkante ermöglicht den einfachen Anschluß der Kontaktfahne an eine externe Strom- oder Spannungsversorgung. Es überragt die Kontaktfahne seitlich oder den Stapel in der Höhe und ist so auch beim Einbau des Stapels in ein Gehäuse noch gut zugänglich und ermöglicht so einen einfachen Stromanschluß.

In der einfachsten Ausführungsform ist das Anschlußelement aus dem Material der Kontaktfahne hergestellt, bzw. integraler Bestandteil der Kontaktfahne. Diese umfaßt zumindest eine elektrisch leitende Schicht. Vorzugsweise besteht sie jedoch aus einem Verbundmaterial mit mindestens einer Kunststoffolie und mindestens einer metallischen Folie oder Schicht. Ein solches Verbundmaterial weist eine hohe Flexibilität bei gleichzeitig hoher Reißfestigkeit und Elastizität auf. Geometrisch stellt das Anschlußelement eine Verlängerung der vom Stapel wegweisenden Außenkante der Kontaktfahne nach oben oder eine Verlängerung der oberen Kante nach außen beziehungsweise zur Seite dar. Neben dem dadurch erleichterten Anschluß dient das Anschlußelement auch zur leichteren Handhabung der Kontaktfahne bzw. des mit der Kontaktfahne versehenen Aktors, insbesondere während des Einbaus in ein Gehäuse. Dabei können die Anschlußelemente als Führung dienen.

Vorzugsweise ist das Anschlußelement daher so ausgebildet, daß es eine zusätzliche mechanische Verstärkung der Außenkante der Kontaktfahne darstellt. In einer vorteilhaften Ausgestaltung ist das Anschlußelement als metallischer Anschlußstift ausgebildet. Dieser kann auf der Kontaktfahne bzw. auf deren metallischer Schicht aufgelötet oder anderweitig elektrisch leitend befestigt sein. Der Anschlußstift kann sich über die gesamte Außenkante erstrecken oder nur mit einem Teil der Kante verbunden sein. Mit einem derartig mechanisch verstärkenden Anschlußelement wird die Führung bzw. Handhabung der am Stapel befestigten Kontaktfahne erleichtert.

Das als Anschlußstift ausgebildete Anschlußelement kann zusätzlich Teil einer elektrischen Steckverbindung sein. Dadurch wird eine äußerst einfache Verbindung zu einer elektrischen Spannungsquelle ermöglicht.

Vorzugsweise weist der Aktor an einer Stirnfläche des Stapels eine Druckplatte auf. Diese besitzt Öffnungen, durch die die Anschlußelemente gesteckt oder geleitet werden. Bei mechanisch verstärkten Anschlußelementen sind die Öffnungen so gestaltet, daß eine Führung und Halterung der Anschlußelemente gewährleistet ist.

Vorzugsweise besitzt die Druckplatte eine Ausnehmung zur Fixierung des Stapels darin. Dies ermöglicht einen sicheren Einbau des Stapels einschließlich der Kontaktfahne in ein Aktorgehäuse, wobei der Stapel sicher ausgerichtet und zentriert wird.

In der Druckplatte können noch andere Elemente des Aktors integriert sein, beispielsweise Kraftsensoren, Temperatursensoren, andere Sensoren (z.B. Hallsensoren) oder ein zweiter Aktor als Justierglied für die Steifigkeit, zur Temperaturausdehnungskompensation und zur Nullpunktsjustierung.

Zum mechanischen Schutz des Stapels im Aktor weist dieser eine Kunststoffumhüllung auf. Dazu ist der Stapel vorzugsweise in eine Kunststoffhülse eingegossen oder mit einem Kunststoff umspritzt. Dafür eignen sich insbesondere Elastomere auf Silikonharzbasis. Der Einbau in die Kunststoffhülse kann dabei mit Hilfe der Druckplatte erfolgen, wobei eine einfache Führung und Fixierung von Stapel, Kontaktfahne und Anschlußelement erreicht wird.

In Längsrichtung des Aktors können beim Eingießen oder Umspritzen mit Kunststoff die anderen bereits oben genannten und den Aktor komplettierenden Elemente mit in die Umhüllung eingebaut werden, sofern sie nicht anderweitig und zum Beispiel in die Druckplattte eingebaut sind.

Im folgenden wird der erfindungsgemäße Aktor sowie ein Verfahren zu dessen Kontaktierung anhand von Ausführungsbeispielen und der dazugehörigen neun Figuren näher erläutert.
- Figur 1: zeigt einen Aktor mit Kontaktfahne und Anschlußelement in schematischer perspektivischer Darstellung.
- Figuren 2 bis 4: zeigen in schematischer Darstellung verschiedene Kontaktfahnen.
- Figuren 5 und 6: zeigen schematische Querschnitte durch erfindungsgemäße Aktoren mit Druckplatte.
- Figur 7: zeigt im schematischen Querschnitt einen Aktor mit Kunststoffhülse.
- Figur 8: zeigt in schematischer perspektivischer Darstellung den Einbau eines Stapels in eine Kunststoffhülse.
- Figur 9: zeigt einen aus mehreren Stapeln aufgebauten Aktor.

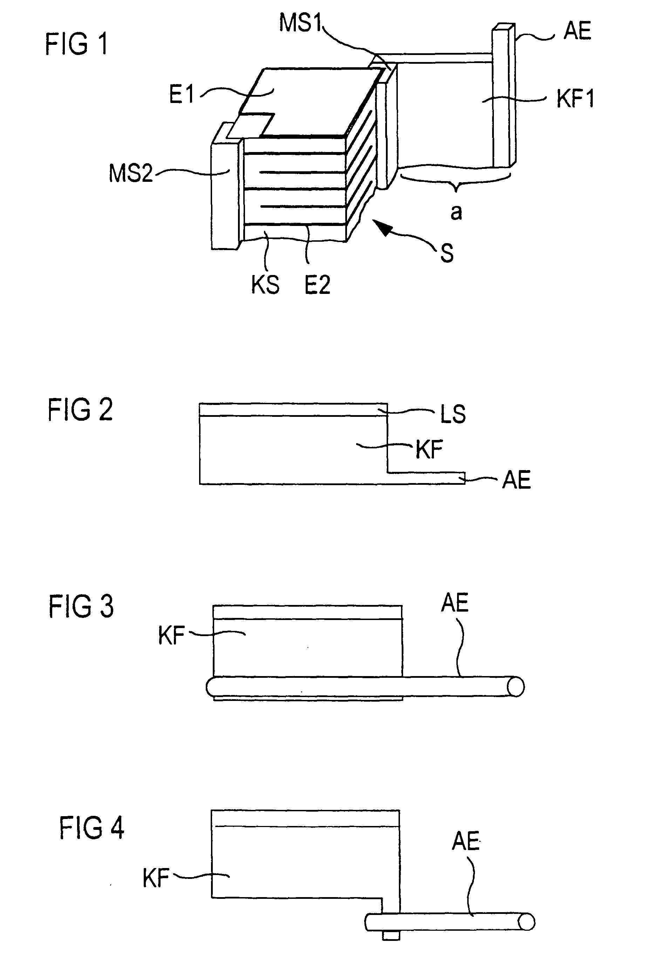

Figur 1 zeigt ausschnittsweise einen erfindungsgemäßen Aktor, bei dem der Übersichtlichkeit halber nur eine Kontaktfahne KF dargestellt ist. Kern des Aktors ist der Stapel S, der alternierend aus Elektrodenschichten E1, E2 und Keramikschichten KS aufgebaut ist. Der hier mit quadratischer Grundfläche dargestellte Aktor ist an einander gegenüberliegenden Ecken mit Metallisierungsstreifen MS versehen, die aufgrund der geometrischen Ausgestaltung der Elektroden E mit jeweils jeder zweiten Elektrode verbunden sind, so daß eine parallele Verschaltung sämtlicher einzelner Aktorelemente möglich ist. Am ersten Metallisierungsstreifen MS1 ist über dessen gesamte Höhe eine Kontaktfahne KF1 mit einer Kante so befestigt, daß ein Teil beziehungsweise der Rest der Kontaktfahne seitlich am Stapel übersteht. Im Bereich der vom Stapel wegweisenden Außenkante ist ein Anschlußelement AE angeordnet, welches den Stapel in der Höhe oder seitlich überragt. Während die Breite des überstehenden Bereichs a ausreichend gewählt wird, daß während des Betriebs oder der Polung des Aktors auftretende Risse in der Metallisierung und insbesondere in den Metallisierungsstreifen MS innerhalb der Kontaktfahne KF auslaufen, ist das Ausmaß, in dem das Anschlußelement AE die Kontaktfahne KF bzw. den Stapel S in der Höhe oder seitlich überragt, von der weiteren Konstruktion des Aktors, dessen Gehäuse oder der weiteren elektrischen Anschlüsse abhängig.

Figur 2 zeigt die einfachste Ausgestaltung der Erfindung, bei der Kontaktfahne und Anschlußelement vorkonfektioniert aus einer elektrisch leitenden Folie, beispielsweise einer kupferkaschierten Kunststoffolie ausgebildet sind. Im Bereich ihrer Innenkante weist die Kontaktfahne eine schmale Lotschicht LS auf, mit deren Hilfe ein einfaches Auflöten der Kontaktfolie an die Metallisierungsstreifen MS möglich ist. Mit Hilfe der Lotschicht kann die Kontaktfahne alternativ auch ohne Metallisierungsstreifen direkt am Stapel beziehungsweise an den Elektrodenschichten befestigt werden.

Ein bevorzugtes und schonendes Verfahren zum Befestigen ist das Laserstrahllöten, das nur eine minimale Wärmebelastung des thermisch empfindlichen Mehrschichtaufbaus erzeugt.

Figur 3 zeigt eine weitere Ausgestaltung der Kontaktfahne KF, die wiederum als Folie mit zumindest einer elektrisch leitenden Schicht ausgebildet ist. Das Anschlußelement AE ist hier als metallischer Anschlußstift ausgebildet, der elektrisch leitend mit der Kontaktfahne KF im Bereich einer Außenkante verbunden und beispielsweise aufgelötet ist. Der Anschlußstift weist beispielsweise einen runden Querschnitt auf.

Figur 4 zeigt eine weitere mögliche Ausgestaltung der Kontaktfahne KF, bei der das Anschlußelement AE eine seitliche Verlängerung der Kontaktfahne darstellt. Es kann wie in der Figur dargestellt mit einem metallischen Anschlußstift verbunden sein und so ein kombiniertes Anschlußelement bilden.

In allen Fällen wird die Kontaktfahne KF vor dem Befestigen an den Metallisierungen oder direkt am Stapel fertig konfektioniert, das heißt, mit Anschlußelementen AE und gegebenenfalls der Lotschicht LS versehen.

Während des Auflötens oder der anderweitigen elektrisch leitenden Befestigung der Kontaktfahne an den Metallisierungen werden diese elektrisch kurzgeschlossen, um eine Beschädigung des zum Beispiel piezoelektrischen Aktors über den pyroelektrischen Effekt zu vermeiden. Mit derselben Maßnahme werden auch bei späteren Verarbeitungsschritten Beschädigungen immer dann vermieden, wenn thermische Belastungen des Stapels zu erwarten sind.

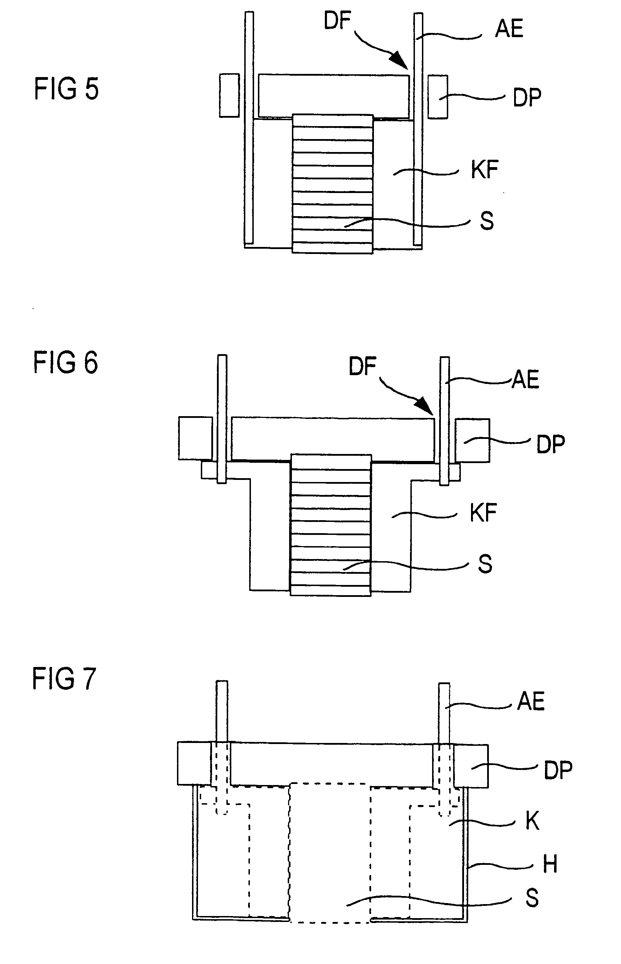

Figur 5 zeigt ein Teilmodul des Aktors, bestehend aus dem mit Kontaktfahnen KF versehenen Stapel S und einer Druckplatte DP, die Durchführungen DF für die Anschlußelemente AE aufweist. Insbesondere bei mechanisch verstärkten Anschlußelementen, beispielsweise den metallischen Anschlußstiften, dienen die Durchführungen DF zur Führung und Halterung sowohl der Anschlußelemente als auch der damit verbundenen Kontaktfahne KF. Die Druckplatte DP ist über einer Stirnfläche des Stapels S angeordnet und weist beispielsweise zur Fixierung des Stapels eine der Stirnfläche angepaßte Vertiefung von ca. 50 bis 100 *µ*m Tiefe auf. Mit diesem Teilmodul wird die Weiterverarbeitung, beispielsweise der Einbau in ein Aktorgehäuse erleichtert, da durch die Fixierung von Stapel S, Kontaktfahne KF und Anschlußelementen AE in der Druckplatte DP die Ausrichtung und Zentrierung des Aktors, die für eine optimale Übertragung der Kräfte erforderlich ist, erleichtert wird.

Figur 6 zeigt ein abgewandeltes Teilmodul mit gemäß Figur 4 ausgestalteten Kontaktfahnen KF und Anschlußelementen AE. Wie in Figur 5 sind auch hier die Anschlußelemente in Durchführungen DF und der Stapel S in einer Ausnehmung der Druckplatte fixiert. In dieser Ausgestaltung ist es möglich, die Kontaktfahnen zunächst ohne Anschlußelemente AE an den Metallisierungsstreifen des Stapels S zu befestigen und dafür die Druckplatte DP fest mit den Anschlußelementen AE zu verbinden. Eine elektrisch leitende Verbindung der Anschlußelemente mit den Kontaktfahnen wird in dieser Ausführungsform nach dem Zusammenfügen von Druckplatte und Stapel vorgenommen, beispielsweise durch Löten. Diese Ausführung hat den Vorteil, daß Druckplatte und Anschlußelemente eine feste Einheit bilden, die beispielsweise gleichzeitig als Steckkontakt zur Verbindung mit einer Strom-/Spannungsquelle dienen können. Die Abdichtung der Durchführungen kann ohne Rücksicht auf eine mechanische oder thermische Belastung des Aktors vorgenommen werden und kann so besonders dicht ausgeführt sein.

Figur 7: Das Teilmodul aus Druckplatte, Anschlußelementen, Kontaktfahnen und Stapel wird zur elektrischen Passivierung und zum mechanischen Schutz mit einer Umhüllung versehen. Im Ausführungsbeispiel ist dazu eine Hülse H vorgesehen, die zum Beispiel aus Kunststoff oder Metall besteht, die der Größe des Teilmoduls angepaßt ist und die mit der Druckplatte dicht abschließt. In diese Hülse H wird das Teilmodul eingesteckt und anschließend über eine freibleibende Öffnung mit Kunststoff K, beispielsweise einem Silikonelastomer vergossen oder umspritzt. Dabei werden sowohl sämtliche elektrisch aktiven Oberflächen des Stapels und der Kontaktfahnen elektrisch und von Umwelteinflüssen isoliert, als auch eine mechanisch feste Verbindung zwischen Hülse H, Druckplatte DP und Stapel S hergestellt. Bei einer aus Kunststoff bestehenden Hülse H bleibt dabei die untere Stirnfläche des Stapels frei, da mit der vorzugsweise keramischen Stirnfläche des Stapels eine bessere Kraftübertragung als mit der Hülse möglich ist.

Vor dem Eingießen oder Einspritzen des Teilmoduls in eine Hülse ist es möglich, die elektrisch aktiven Oberflächen des keramischen Mehrschichtstapels S zusätzlich zu passivieren, insbesondere durch Auftrag einer elektrisch isolierenden ausreichend elastischen Kunststoffmasse, beispielsweise wiederum einem Silikonelastomer. Die Passivierung wird durch die Halterung der Kontaktfahne über die in der Druckplatte fixierten Anschlußelemente erleichtert. Außerdem verhindert die Passivierung, daß durch die beim Umspritzen oder Vergießen auftretenden und auf die Kontaktfahnen KF einwirkenden mechanischen Kräfte ein Kurzschluß zwischen einer Kontaktfahne und einem elektrisch aktiven Oberflächenbereich des Stapels erfolgt, der zu einer Fehlfunktion des Aktors führen könnte.

Erfolgt der Auftrag der Passivierung vor der Herstellung eines Teilmoduls aus Stapel und Druckplatte, so können die flexiblen Kontaktfahnen KF dabei anderweitig über die Anschlußelemente AE fixiert werden, so daß die Passivierung, beispielsweise durch Pinselauftrag, erleichtert wird. Dazu können die Anschlußelemente und gegebenenfalls auch der Stapel in einer Hilfshalterung fixiert werden. Die Passivierung der Stapeloberflächen vor dem Zusammenfügen des genannten Teilmoduls hat den Vorteil, daß die Kontaktfahnen KF nun vor der Weiterverarbeitung enger am Stapel angeordnet und beispielsweise auch angelegt werden können. Damit wird eine raumsparendere Anordnung in einer Hülse H möglich. Ein Stapel mit an den Seitenflächen anliegenden Kontaktfahnen ist mechanisch stabiler und zusätzlich vor mechanischen Beschädigungen während des Einbaus in die Hülse oder in ein Aktorgehäuse geschützt. In einer Ausgestaltung der Erfindung ist es möglich, die Kontaktfahnen an die Seitenflächen des Stapels anzudrükken und dort zu fixieren, beispielsweise durch einen elastischen Kunststoffring, der über den Stapel samt anliegenden Kontaktfahnen und Anschlußelementen geschoben wird und Kontaktfahnen und Anschlußelemente eng an den Stapel andrückt.

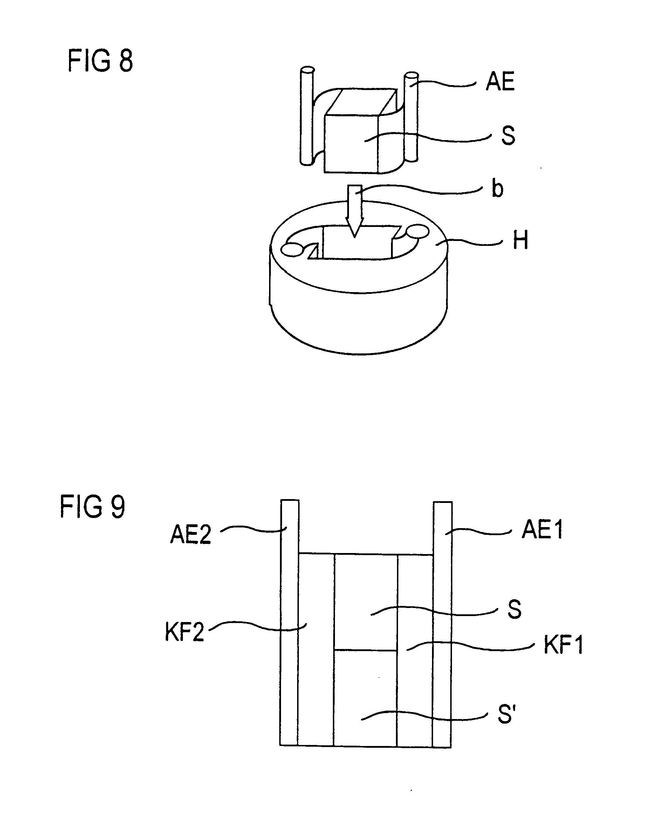

Figur 8 zeigt eine weitere Ausgestaltung der Erfindung, mit der ein sicherer Einbau des Stapels samt Kontaktfahne und Anschlußelemente in eine Kunststoffhülse H möglich ist. Die Kunststoffhülse ist dabei nicht als leerer Hohlzylinder ausgebildet, sondern weist bereits ein Innenprofil auf, das der geometrischen Form von Stapel, Kontaktfahne und Anschlußelementen angepaßt ist. Nach dem Einbringen des Stapels in das vorgebildete Innenprofil der Hülse H (siehe Richtungspfeil b) sind sowohl Stapel als auch Kontaktfahnen und Anschlußelemente ausreichend fixiert. Beim nun folgenden Auffüllen mit Kunststoff der verbleibenden Zwischenräume zum Innenprofil wird so eine Beschädigung der Kontaktfahnen bzw. ein ungewollter Kurzschluß zwischen Kontaktfahnen und gegebenenfalls freiliegenden elektrisch aktiven Oberflächen des Stapels vermieden. Auch in dieser Ausführung können sowohl die Anschlußelemente AE als auch der Stapel S in einer Halterung, beispielsweise einer Druckplatte DP (in Figur 8 nicht dargestellt) fixiert sein, um sowohl ein leichteres Einbringen des Stapels in die Hülse H zu ermöglichen, als auch eine einseitig hermetisch dichte Versiegelung des Stapels in der Hülse zu ermöglichen.

Figur 9 zeigt eine weitere Ausgestaltung der Erfindung, die mit sämtlichen bereits beschriebenen Darstellungen kombiniert werden kann. Diese umfaßt einen aus zwei übereinander angeordneten Stapeln S, S' bestehenden Mehrschichtaufbau, bei dem die Stapel S und S' mittels gemeinsamer Kontaktfahnen KF verbunden und damit gegeneinander fixiert sind. Mechanisch verstärkte Anschlußelemente AE, beispielsweise metallische Anschlußstifte stabilisieren die Anordnung zusätzlich. Auf diese Weise ist es möglich, aus technologisch einfacher herzustellenden niedrigen Stapeln dennoch die nötige Gesamthöhe an Mehrschichtaufbau und damit an möglicher Auslenkung des Aktors zu erreichen, und dabei eine einfache und elegante Verbindung der beiden Teilstapel S, S' zu erzielen. Hilfshalterung kann auch hier zur frühzeitigen Zentrierung von mehreren Stapeln übereinander dienen, wobei letztere bereits an einer Druckplatte angeordnet und ausgerichtet werden können. Damit wird die Laserstrahllötung der gemeinsamen Kontaktfahnen KF an die Stapel S und S' vereinfacht und die Zentrierung der Stapel beim Spritzguß erleichtert.

## Patentansprüche

1. Keramischer Aktor
- mit einem Mehrschichtaufbau, umfassend zumindest einen Stapel (S) alternierender Elektroden- (E) und Keramikschichten (KS),
- mit zumindest zwei, seitlich an jedem Stapel angebrachten streifenförmigen, elektrisch leitenden Kontaktfahnen (KF);
- **dadurch gekennzeichnet, daß** jede Kontaktfahne (KF) über eine Kante elektrisch leitend mit den Elektrodenschichten verbunden ist und seitlich dieser Kante einen überstehenden Bereich (a) aufweist;
- jede kontaktfahne ein, die Kontaktfahne seitlich oder den Stapel in der Höhe überragendes, elektrisches Anschlußelement (AE) aufweist, das im Bereich der vom Stapel wegweisenden Außenkante der jeweiligen Kontaktfahne angeordnet ist.

2. Aktor nach Anspruch 1,
bei dem das Anschlußelement (AE) einen metallischen Anschlußstift umfaßt, der die Außenkante der Kontaktfahne (KF) mechanisch verstärkt und sich entlang der Außenkante über deren gesamte Höhe erstreckt.

3. Aktor nach Anspruch 1 oder 2,
bei dem das Anschlußelement (AE) eine streifenförmige Verlängerung der Kontaktfahne umfaßt, die mit metallischen Anschlußstiften verbunden ist.

4. Aktor nach Anspruch 2 oder 3
bei dem eine Druckplatte (DP) über einer Stirnfläche des Stapels (S) angeordnet ist, durch die die Anschlußstifte (AE) gesteckt und dort fixiert sind.

5. Aktor nach einem der Ansprüche 2 bis 4,
bei dem die Anschlußstifte (AE) als Steckkontakt ausgebildet sind.

6. Aktor nach Anspruch 4,
bei dem in der Druckplatte (DP) eine Ausnehmung vorgesehen ist, in der der Stapel (S) fixiert ist.

7. Aktor nach einem der Ansprüche bis 6,
bei dem Stapel (S) und Kontaktfahnen (KF) in einer kompakten Kunststoffumhüllung allseitig mit Kunststoff (K) umspritzt oder vergossen sind, und bei dem die elektrischen Anschlußelemente (AE) stirnseitig aus der Kunststoffumhüllung (H) herausgeführt sind.

8. Aktor nach Anspruch 7,
bei dem die Kunststoffumhüllung aus einem Silikonelastomeren (K) ausgebildet ist.

9. Aktor nach einem der Ansprüche 1 bis 7,
bei dem mehrere Stapel (S, S') übereinander angeordnet und mit gemeinsamen Kontaktfahnen, (KF) verbunden sind.

10. Verfahren zur Kontaktierung eines keramischen Aktors mit Mehrschichtaufbau,
- bei dem ein den Mehrschichtaufbau bildender Stapel (S) aus alternierenden Elektroden- und Keramikschichten (E1, KS, E2) hergestellt wird
- bei dem aus einer Folie, die zumindest eine elektrisch leitende Schicht umfaßt, in der Größe der Höhe des Mehrschichtaufbaus angepaßte Kontaktfahnen (KF) Gefertigt und darin im Bereich einer Kante der Kontaktfahne elektrische Anschlußelemente (AE) vorgesehen werden, die die Kontaktfahne seitlich oder den Mehrschichtaufbaus in der Höhe überragen,
- bei dem zumindest zwei Kontaktfahnen über eine Kante seitlich so an dem Stapel (S) befestigt werden, daß ein seitlich überstehender Bereich (a) verbleibt, wobei ein elektrisch leitender Kontakt zu den Elektrodenschichten hergestellt wird.

11. Verfahren nach Anspruch 10,
bei dem der Stapel (5) zur Kontaktierung der Elektrodenschichten seitlich mit zumindest zwei streifenförmigen Metallisierungen (MS) versehen wird und bei dem die Kontaktfahnen an den streifenförmigen Metallisierungen befestigt werden.

12. Verfahren nach Anspruch 10 oder 11,
bei dem das Befestigen durch Laserlöten erfolgt.

13. Verfahren nach einem der Ansprüche 10 bis 12,
bei dem als Anschlußelemente (AE) Metallstifte vorgesehen werden, die vor dem Befestigen der Kontaktfahnen (KF) im Bereich der dem Stapel gegenüber liegenden Kante auf den Kontaktfahnen aufgelötet werden.

14. Verfahren nach einem der Ansprüche 10 bis 13,
bei dem die elektrisch aktive Oberfläche des Stapels (S) nach dem Befestigen der Kontaktfahnen (KF) mit einer elektrisch isolierenden organischen Passivierungsschicht so abgedeckt wird, daß von der Kontaktfahnen zumindest die Anschlußelemente (AE) und vom Stapel (S) die Stirnflächen frei bleiben.

15. Verfahren nach einem der Ansprüche 10 bis 14,
bei dem der Stapel (S) nach dem Befestigen der Kontaktfahnen (KF) in eine Kunststoffhülse (H) geschoben und mit Kunststoff (K) so vergossen oder umspritzt wird, daß die Enden der Anschlußelemente (AE) frei bleiben.

16. Verfahren nach Anspruch 15,
bei dem eine Druckplatte (DP) mit Durchführungen (DF) vorgesehen wird, durch die die Anschlußelemente (AE) geführt werden,
bei dem der Stapel (S) in der Druckplatte (DP) fixiert und anschließend in der Kunststoffhülse (H) vergessen oder umspritzt wird.

17. Verfahren nach einem der Ansprüche 10 bis 16,
bei dem zwei Stapel (S, S') übereinander angeordnet, mit gemeinsamen Kontaktfahnen (KF1, KF2) versehen und so zu einem Doppelstapel verbunden werden.

## Claims

1. Ceramic actuator
- with a multilayer structure, having at least one stack (S) of alternating electrode layers (E) and ceramic layers (KS);
- with at least two strip-shaped electrically-conductive contact lugs (KF), which are attached to each stack laterally,
**characterised in that**
- each contact lug (KF) is connected to the electrode layers in an electrically-conductive manner by way of an edge and has a protruding region (a) to the side of said edge;
- each contact lug (KF) has an electrical terminal element (AE) projecting beyond the contact lug laterally or beyond the height of the stack, disposed in the region of the outer edge of the respective contact lug facing away from the stack.

2. Actuator according to claim 1,
wherein the terminal element (AE) has a metal terminal pin, which mechanically reinforces the outer edge of the contact lug (AE) and extends along the outer edge over the entire height of the contact lug.

3. Actuator according to claim 1 or 2,
wherein the terminal element (AE) has a strip-shaped extension of the contact lug, which is connected to metal terminal pins.

4. Actuator according to claim 2 or 3,
wherein a pressure plate (DP) is disposed over a front face of the stack (S), through which pressure plate (DP) the terminal pins (AE) are inserted and fixed thereto.

5. Actuator according to one of claims 2 to 4,
wherein the terminal pins (AE) are configured as plug-in contacts.

6. Actuator according to claim 4,
wherein a recess is provided in the pressure plate (DP), in which recess the stack (S) is fixed.

7. Actuator according to one of claims 1 to 6,
wherein plastic is moulded or cast all round the stack (S) and contact lugs (KF) to form a compact plastic envelope and
wherein the electrical terminal elements (AE) exit from the plastic envelope (H) on a front face.

8. Actuator according to claim 7,
wherein the plastic envelope is made from a silicone elastomer (K).

9. Actuator according to one of claims 1 to 7,
wherein a number of stacks (S, S') are disposed one above the other and connected to common contact lugs (KF).

10. Method for contacting a ceramic actuator with a multilayer structure,
- wherein a stack (S) forming the multilayer structure is made from alternating electrode layers and ceramic layers (E1, KS, E2),
- wherein contact lugs (KF) tailored in size to the height of the multilayer structure are made of a film having at least one electrically-conductive layer and electrical terminal elements (AE) are provided therein in the region of an edge of the contact lug, said terminal elements (AE) projecting beyond the contact lug laterally or beyond the height of the multilayer structure,
- wherein at least two contact lugs are connected by way of an edge to the stack (S) laterally, such that a laterally protruding region (a) remains, with an electrically-conductive contact with the electrode layers being produced.

11. Method according to claim 10,
wherein the stack (S) is provided laterally with at least two strip-shaped metallizing components (MS) to enable contacting of the electrode layers and wherein the contact lugs are secured to the metallizing strip-shaped components.

12. Method according to claim 10 or 11,
wherein the securing is carried out by laser soldering.

13. Method according to one of claims 10 to 12,
wherein metal pins are provided as the terminal elements (AE), said metal pins being soldered to the contact lugs before the contact lugs (KF) are secured in the region of the edge opposite the stack.

14. Method according to one of claims 10 to 13,
wherein the electrically-active surface of the stack (S) is covered, after the securing of the contact lugs (KF), with an electrically-insulating organic passivation layer, such that at least the terminal elements (AE) of the contact lugs remain free and the front faces of the stack (S) remain free.

15. Method according to one of claims 10 to 14,
wherein, after the contact lugs (KF) have been secured, the stack (S) is inserted into a plastic sleeve (H) and plastic (K) is cast or moulded around it such that the ends of the terminal elements (AE) remain free.

16. Method according to claim 15,
wherein a pressure plate (DP) is provided with through-holes (DF), through which the terminal elements (AE) are passed,
wherein the stack (S) is fixed in the pressure plate (DP) and is then cast or moulded in the plastic sleeve (H).

17. Method according to one of claims 10 to 16,
wherein two stacks (S, S') are disposed one above the other, provided with common contact lugs (KF1, KF2) and thus connected to form a double stack.

## Revendications

1. Actionneur céramique, comprenant
- une construction à plusieurs couches, comportant au moins une pile (S) de couches alternantes d'électrodes (E) et de céramique (KS) ;
- au moins deux languettes de contact (KF) électriquement conductrices en forme de bandes et fixées latéralement sur chaque pile,
**caractérisé en ce**
- **que** chaque languette de contact (KF) est connectée de manière électriquement conductrice aux couches d'électrodes par une arête et comprend une partie (a) faisant latéralement saillie par rapport à cette arête ;
- **que** chaque languette de contact comporte un élément de connexion électrique (AE) dépassant latéralement la languette de contact ou dépassant la pile en hauteur, cet élément étant disposé dans la zone de l'arête extérieure s'étendant en sens opposé de la pile, de la languette de contact respective.

2. Actionneur selon la revendication 1, dans lequel l'élément de connexion (AE) comprend une broche de connexion métallique qui renforce mécaniquement l'arête extérieure de la languette de contact (KF) et qui s'étend le long de l'arête extérieure sur toute sa longueur.

3. Actionneur selon la revendication 1 ou 2, dans lequel l'élément de connexion (AE) comprend un prolongement de la languette de contact sous forme de bande qui est reliée à des broches de connexion métalliques.

4. Actionneur selon la revendication 2 ou 3, dans lequel une plaque de compression (DP) est disposée au-dessus d'une face frontale de la pile (S), les broches de connexion (AE) étant passées à travers la plaque et fixées dans celle-ci.

5. Actionneur selon l'une des revendications 2 à 4, dans lequel les broches de connexion (AE) sont réalisées en forme de contact enfichable.

6. Actionneur selon la revendication 4, dans lequel un évidement est prévu dans la plaque de compression (DP), dans lequel la pile (S) est fixée.

7. Actionneur selon l'une des revendications 1 à 6, dans lequel la pile (S) et les languettes de contact (KF) sont enrobées ou coulées de tous les côtés par une matière synthétique (K) dans une enveloppe compacte en matière synthétique, et dans laquelle des éléments de connexion électriques (AE) sont sortis frontalement de l'enveloppe en matière synthétique (H).

8. Actionneur selon la revendication 7, dans lequel l'enveloppe en matière synthétique est formée par un élastomère de silicone (K).

9. Actionneur selon l'une des revendications 1 à 7, dans lequel plusieurs piles (S, S') sont disposées en superposition et connectées par des languettes de contact (KF) communes.

10. Procédé pour la mise en contact d'un actionneur céramique ayant une construction multicouche,
- dans lequel une pile (S) de couches alternantes d'électrodes et de céramique (E1, KS, E2) formant le montage multicouche est fabriquée,
- dans lequel des languettes de contact (KF) sont fabriquées à partir d'une feuille comportant au moins une couche électriquement conductrice, la grandeur de ces languettes étant adaptée à la hauteur du montage multicouche, des éléments de connexion électrique (AE) étant prévus dans la zone d'une arête de la languette de contact qui dépassent latéralement la languette de contact ou dépassent en hauteur le montage multicouche,
- dans lequel au moins deux languettes de contact sont fixées latéralement à la pile (S) par une de leurs arêtes, de telle façon qu'une partie (a) dépasse latéralement la pile, un contact électriquement conducteur étant réalisé vers les couches d'électrodes.

11. Procédé selon la revendication 10, dans lequel la pile (S) est équipée latéralement de deux métallisations (MS) en forme de bande pour la mise en contact des couches d'électrodes, et dans lesquelles les languettes de contact sont fixées sur les métallisations en forme de bande.

12. Procédé selon la revendication 10 ou 11, dans lequel la fixation est effectuée par une soudure au laser.

13. Procédé selon l'une des revendications 10 à 12, dans lequel on prévoit comme éléments de connexion (AE) des broches métalliques qui sont soudées sur les languettes de contact avant la fixation des languettes de contact (KF) dans la zone de l'arête opposée à la pile.

14. Procédé selon l'une des revendications 10 à 13, dans lequel la surface électriquement active de la pile (S) est recouverte, après la fixation des languettes de contact (KF), d'une couche de passivation organique électriquement isolante de telle manière qu'au moins les éléments de connexion (AE) des languettes de contact restent libres et les surfaces frontales de la pile (S) restent également libres.

15. Procédé selon l'une des revendications 10 à 14, dans lequel la pile (S) est insérée, après la fixation des languettes de contact (KF), dans une douille (H) en matière synthétique et qu'elle est coulée ou enrobée en une matière synthétique (K), de telle sorte que les extrémités des éléments de connexion (AE) restent libres.

16. Procédé selon la revendication 15, dans lequel une plaque de compression (DP) présentant des passages (DF) est prévue à travers laquelle les éléments de connexion (AE) sont passés, dans lequel la pile (S) est fixée dans la plaque de compression (DP) et coulée ou enrobée dans la douille en matière synthétique (H).

17. Procédé selon l'une des revendications 10 à 16, dans lequel deux piles (S, S') sont disposées en superposition, équipées de languettes de contact communes (KF1, KF2) et reliées de cette manière pour former une pile double.
